# EUROPEAN PATENT SPECIFICATION

(11) **EP 3 045 827 B1**
(45) Date of publication and mention of the grant of the patent: **21.10.2020**
(21) Application number: 13892989.8
(22) Date of filing: 09.09.2013
(51) Int. Cl.: F24F 1/0018, F24F 1/0053, H05K 7/20

(54) **AIR CONDITIONER**
KLIMAANLAGE
APPAREIL DE CONDITIONNEMENT D'AIR

(43) Date of publication of application: 20.07.2016
(73) Proprietor: Mitsubishi Electric Corporation, Tokyo 100-8310 (JP)
(72) Inventor: IKEDA, Takashi, Tokyo 100-8310 (JP); KAWAI, Kazuhiko, Tokyo 100-8310 (JP); MOCHIZUKI, YUKI, Tokyo 100-8310 (JP); SHINODA, Ippei, Tokyo 100-8310 (JP); YATA, Yuichi, Tokyo 100-8310 (JP)
(74) Representative: Pfenning, Meinig & Partner mbB
(86) International application number: PCT/JP2013/074236
(87) International publication number: WO 2015/033467

(56) References cited:
- EP-A1- 2 587 174
- EP-A1- 2 587 175
- JP-A- H06 331 169
- JP-A- H07 332 701
- JP-A- H07 332 701
- JP-A- 2004 040 885
- JP-A- 2006 010 177
- JP-A- 2007 085 219
- JP-A- 2010 159 659
- JP-A- 2011 202 821

## Description

### Technical Field

The present invention relates to an air conditioning apparatus.

### Background Art

Patent Literature 1 and Patent Literature 2 disclose air conditioning apparatus of a downward-blowing type, which are used for air-conditioning a computer room and the like. Patent Literature 1 and Patent Literature 2 disclose the air conditioning apparatus each having such a configuration that a V-shaped or inverted V-shaped heat exchanger is arranged on an upstream side of a blower fan. The blower fan includes a plurality of impellers, a plurality of volute fan casings arranged around the corresponding impellers, and a motor for driving the impellers. Each of the impellers is arranged so that a rotation axis thereof is directed to a horizontal direction. Further, air inlets of the blower fan are directed sideways, and air outlets of the blower fan are directed downward. The plurality of impellers are driven by one motor.

In each of the air conditioning apparatus, the air is sucked from a unit air inlet formed in an upper surface of a unit, and the air that is conditioned into a desired state is blown out from a unit air outlet formed in a lower surface of the unit, toward an underfloor space in which the air conditioning apparatus is placed. The air passes through the underfloor space and gradually flows out upward from a surface of a floor, and thus a computer and a room are subjected to an air-conditioning effect.

Further, Patent Literature 3 discloses an air conditioning apparatus in which two heat exchangers are arranged in an inverted V-shape so that lower portions of the heat exchangers are spaced apart from each other. Side block plates are arranged on both side surfaces of the two heat exchangers, and an upper block plate is arranged on upper portions of the two heat exchangers. Drain pans for collecting dew condensation water are arranged below the heat exchangers, respectively. A blower fan, which is arranged inside a unit, sucks the air from a unit air inlet formed in a lower portion of the unit. After the blower fan causes the sucked air to pass through the heat exchangers arranged in an inverted V-shape as described above, and then subjects the sucked air to desired heat exchange, the blower fan blows out the air from a unit air outlet formed in an upper portion of the unit, and blows out the air toward an air outlet duct provided to the unit air outlet. Further, the blower fan is configured so that a fan air inlet thereof is directed to a side surface of the unit and a fan air outlet thereof is directed to an upper surface of the unit.

EP 2587174 A1 discloses a climate control machine. The climate control machine of the type has a function for cooling by introducing external air, which comprises a cabinet with heat exchange means, proximate to which there are one or more fans which are adapted to aspirate air from a first shutter for the inflow of air that arrives from the internal environment (AI), or from a second shutter for the inflow of air that arrives from the outside (AE) for the "free cooling" function, or from both shutters. The heat exchange means are interposed between the first shutter and the one or more fans, whereas the space between the second shutter and the fans is free from the space occupation caused by the heat exchange means.

EP 2 587 174 A1 thereby discloses an air conditioning apparatus according to the preamble of claim 1.

### Citation List

### Patent Literature

[PTL 1] JP 6-12465 Y2 (pp. 1 and 2, FIG. 2)
[PTL 2] JP 2011-202821 A (pp. 5 to 7, FIG. 2)
[PTL 3] JP 9-273801 A (pp. 2 and 3, FIGS. 1)

### Summary of Invention

### Technical Problems

However, the above-mentioned related-art air conditioning apparatus have the following problems.

First, in the air conditioning apparatus disclosed in Patent Literatures 1 and 2, there is a problem in that, when an airflow blown out from the impellers collides with the underfloor space, airflow resistance is high particularly in a place where a height of the underfloor space is low, and hence power consumption of the motor is increased. Further, the blown-out airflow may stir up dust underneath the floor.

Further, in the air conditioning apparatus disclosed in Patent Literature 3, there is a problem in that, when an airflow blown out from the impeller flows into and collides with the air outlet duct provided to the unit air outlet, airflow resistance is high, and hence power consumption of a motor is increased.

The present invention has been made in view of the above-mentioned problems, and has an object to provide an air conditioning apparatus capable of reducing power consumption of a motor along with reduction in airflow resistance.

### Solution to Problems

The object of the present invention is solved by claim 1. Advantageous embodiments are described by the dependent claims.

In order to achieve the above-mentioned object, according to one embodiment of the present invention, there is provided an air conditioning apparatus, including: a unit main body; a heat exchanger; and at least one blower fan. The heat exchanger is arranged on an upstream side of the blower fan. The blower fan includes an impeller, a motor, and a fan casing. The impeller is a turbofan that sucks air from an upper portion thereof and blows out the air radially outward. A rotation axis of the impeller is directed to a unit height direction. The fan casing has a fan air inlet formed in an upper surface thereof, and has a fan air outlet formed in a lower surface thereof. An impeller air outlet of the impeller is covered by side surfaces of the fan casing.

The blower fan may be arranged below the heat exchanger.

The impeller includes a plurality of blades, a side plate having a ring shape, and a main plate, the side plate is positioned on the fan air inlet side, the main plate is positioned on the fan air outlet side, and an outer diameter ϕDs of the side plate is larger than an outer diameter ϕDm of the main plate.

An outer diameter ϕDb1 of each of the blades on the side plate side may be larger than an outer diameter ϕDb2 of each of the blades on the main plate side.

The blower fan may include a plurality of blower fans.

The plurality of blower fans may be arranged with an interval in a widthwise direction.

The plurality of blower fans may be controlled so as to have mutually different numbers of revolutions of the fans.

The fan casing may include a frame body, and at least one side wall surface removably mounted to the frame body.

The blower fan may include a motor support for supporting the motor, and the motor support may be positioned closer to a side on which the fan air outlet is formed than the main plate of the impeller.

The side surfaces of the fan casing may include at least one flat surface.

The fan casing may include at least one chamfered portion that, with reference to a rectangular shape of the fan casing in plane view, at a portion corresponding to a corner of the rectangular shape.

The heat exchanger may have a shape including at least one bent portion.

The heat exchanger may have an inverted V-shape or an M-shape .

### Advantageous Effects of Invention

According to the one embodiment of the present invention, reduction in power consumption of the motor along with reduction in airflow resistance can be achieved.

### Brief Description of Drawings

FIG. 1 is an external perspective view illustrating an air conditioning apparatus according to a first embodiment of the present invention.
FIG. 2 is aside longitudinal cross-sectional view illustrating the air conditioning apparatus of FIG. 1.
FIG. 3 is a front longitudinal cross-sectional view illustrating the air conditioning apparatus of FIG. 1.
FIG. 4 is a perspective view illustrating a blower fan of the air conditioning apparatus of FIG. 1.
FIG. 5 is a cross-sectional view taken along the line V-V of FIG. 2.
FIG. 6 is a cross-sectional view taken along the line VI-VI of FIG. 5.
FIG. 7 is a view schematically illustrating an airflow formed inside the blower fan of FIG. 4.
FIG. 8 is a view illustrating a second embodiment of the present invention and corresponding to FIG. 5.
FIG. 9 is a view illustrating a third embodiment of the present invention and corresponding to FIG. 2.
FIG. 10 is a view illustrating a modified example of the third embodiment and corresponding to FIG. 3.
FIG. 11 is a view illustrating the modified example of the third embodiment and corresponding to FIG. 2.

### Description of Embodiments

Now, an air conditioning apparatus according to embodiments of the present invention is described with reference to the accompanying drawings. Note that, in the drawings, the same reference symbols represent the same or corresponding parts. The air conditioning apparatus according to the embodiments of the present invention can be used for, as an example, a computer room in which air cleaning, dehumidifying, and air-cooling are performed.

### First Embodiment

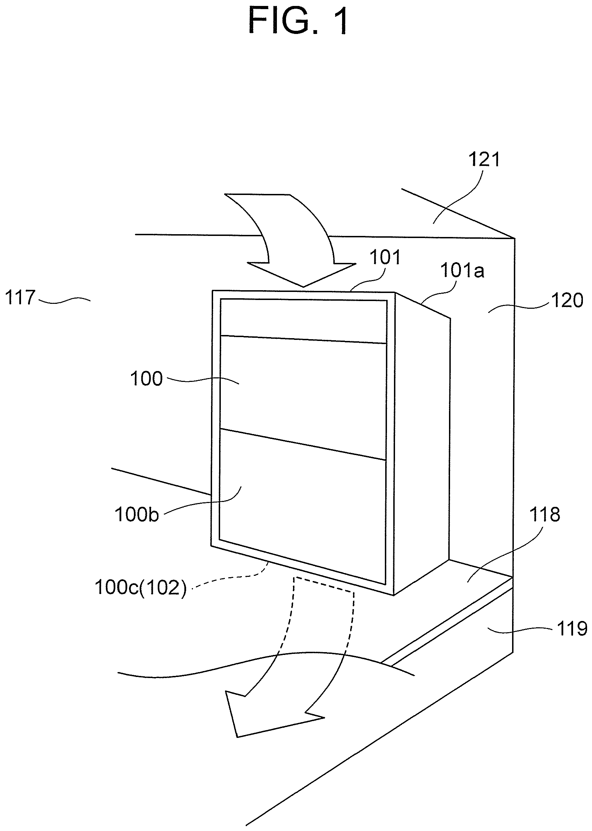

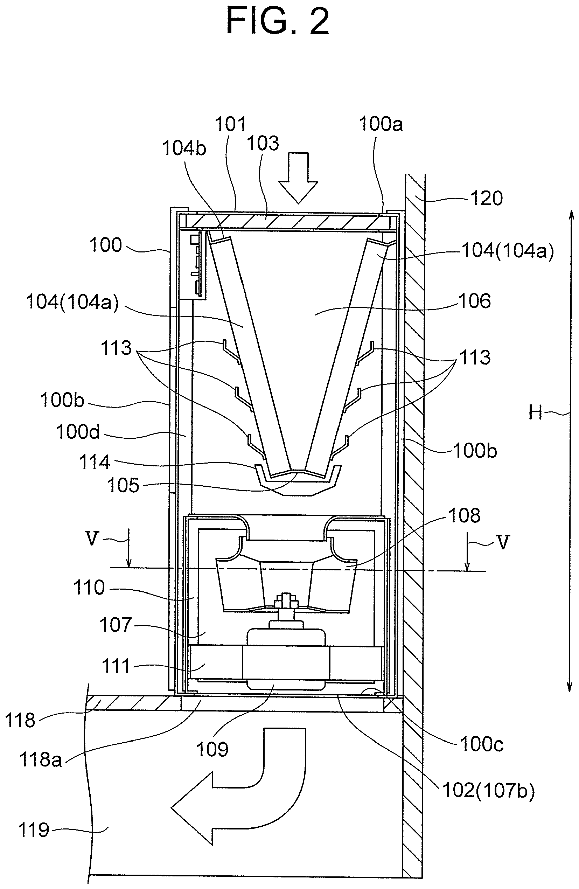

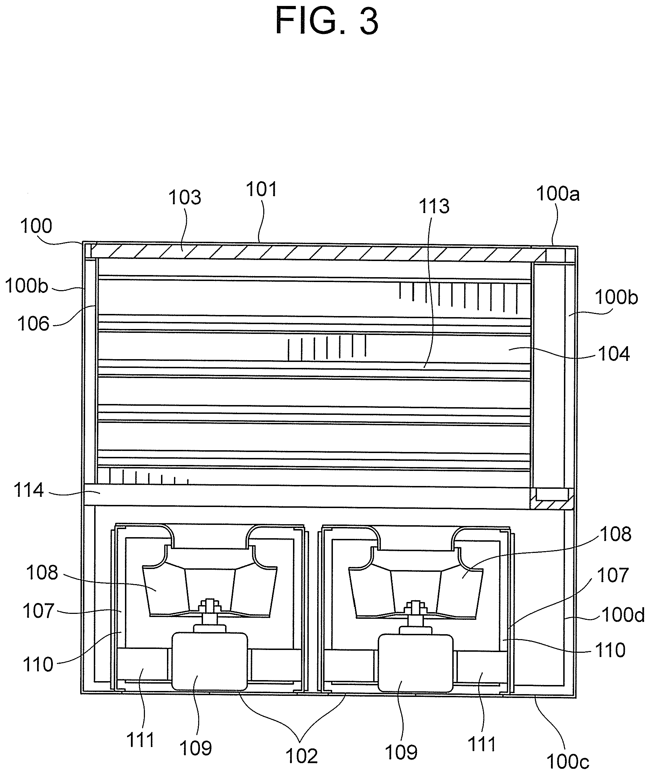

FIG. 1 is an external perspective view illustrating an air conditioning apparatus according to a first embodiment of the present invention. FIG. 2 is a side longitudinal cross-sectional view illustrating the air conditioning apparatus of FIG. 1, and FIG. 3 is a front longitudinal cross-sectional view illustrating the air conditioning apparatus of FIG. 1.

In FIGS. 1 to 3, a contour of a unit main body 100 is formed in such a manner that a main body top plate 100a having a unit air inlet 101 formed in an upper surface of the main body, main body side plates 100b, and a main body bottom plate 100c having a unit air outlet 102 formed in a lower surface of the main body are mounted to a main body frame 100d. Each of the main body side plates 100b is divided so as to have a configuration capable of being dismounted separately for maintenance of an inside of the main body.

Further, the unit main body 100 is arranged between a ceiling 121 and a floor 118 of a room 117, that is, placed on the floor 118. In many cases, the unit main body 100 is arranged along a wall 120. The floor 118 has double flooring structure. An opening hole 118a is formed in the floor 118 so as to be communicated to an underfloor space 119.

Inside the unit main body 100, an air cleaning filter 103 is removably mounted to the unit air inlet 101.

The floor 118, on which the unit main body 100 is placed, has a plurality of opening portions formed in portions thereof on a downstream side of a flow of the air-conditioned air. The air-conditioned air is supplied, through the opening portions, to a computer storage rack and an air conditioning apparatus that is separately placed, and thus computers are cooled. That is, in the entire room, there is formed a circulating flow including an airflow flowing upward from below around an object to be cooled.

On a downstream side of the unit air inlet 101, a heat exchanger 104, a drain pan 114 for collecting condensed water, and two blower fans 107 are arranged. The drain pan 114 for collecting condensed water is arranged below the heat exchanger 104, and the blower fans 107 are arranged below the drain pan 114.

The heat exchanger 104 includes two heat exchanger forming sections 104a each having a flat-plate-like shape, and is supported by a bracket 104b. The heat exchanger forming sections 104a are arranged in a V-shape so that an interval between end portions of the heat exchanger forming sections 104a on a unit upper side is larger than an interval between end portions of the heat exchanger forming sections 104a on a unit lower side. A coupling plate 105 is mounted between the end portions of the pair of heat exchanger forming sections 104a on the unit upper side, and fixing plates 106 are mounted to the pair of heat exchanger forming sections 104a on both sides of the unit (on both front and back sides of the drawing sheet of FIG. 2). With this, the air sucked into the unit is accelerated to reach the blower fans 107 after flowing through the heat exchanger forming sections 104a.

The heat exchanger 104 is connected, through a refrigerant pipe, to an outdoor unit (not shown) including a compressor arranged therein. Further, on a downstream side portion of each of the heat exchanger forming sections 104a, a plurality of sub-drain pans 113 are arranged. With this, even if dew condensation water drips down from the heat exchanger 104, drops of water are collected in the sub-drain pans 113, and can be discharged into the drain pan 114.

As illustrated in FIG. 3, the blower fans 107 each include an impeller 108, a motor 109, a fan casing 110, and a motor support 111. The two blower fans 107 are arranged with an interval in a widthwise direction. More specifically, the two blower fans 107 are arranged so that adjacent fan casings 110 described later are separated from each other. Further, as an example, the two blower fans are controlled so as to have mutually different numbers of revolutions of the fans. Note that, in a specific example of the first embodiment, the two blower fans are provided, but this embodiment and the present invention are not limited thereto. Three or more blower fans may be provided.

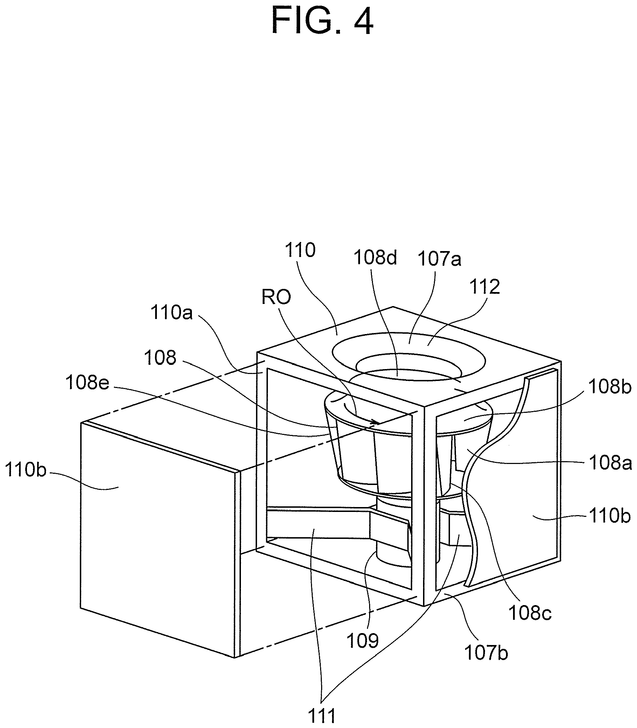

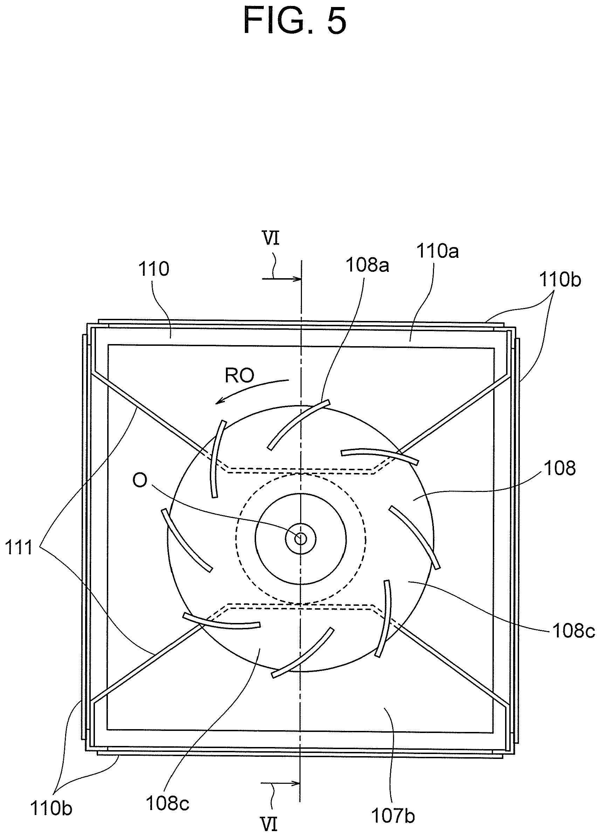

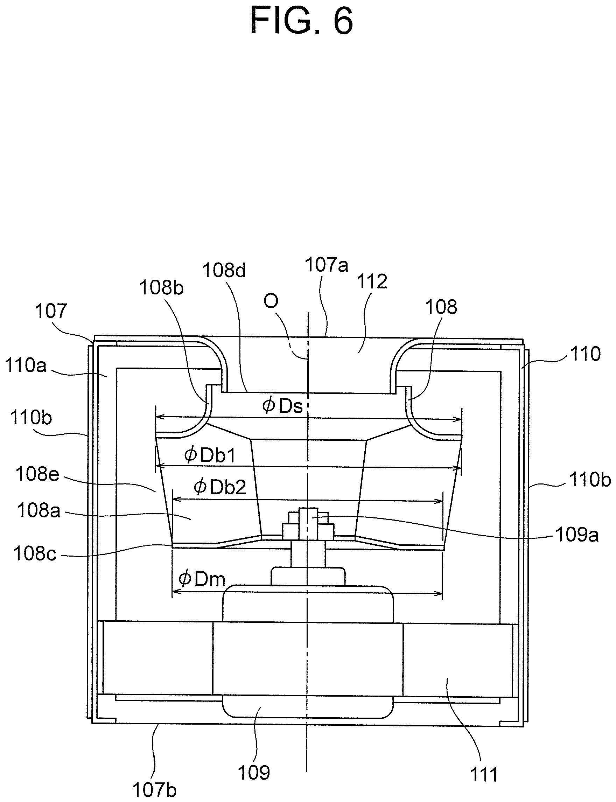

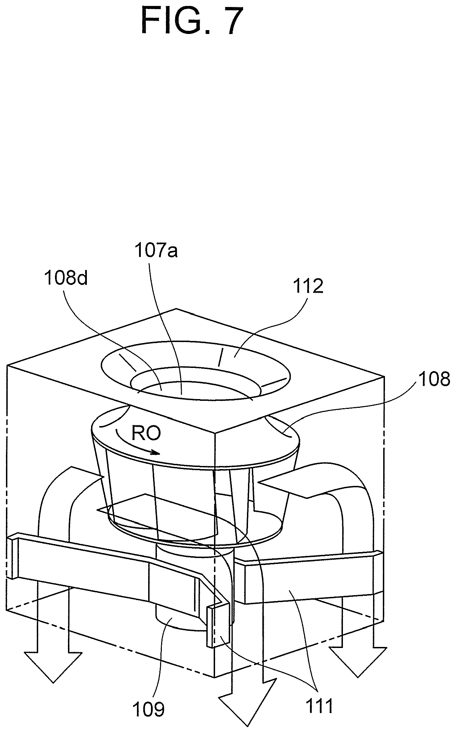

Next, details of the blower fans are described. FIG. 4 is a perspective view illustrating one of the blower fans of the air conditioning apparatus of FIG. 1. FIG. 5 is a cross-sectional view taken along the line V-V of FIG. 2. FIG. 6 is a cross-sectional view taken along the line VI-VI of FIG. 5. FIG. 7 is a view schematically illustrating an airflow formed inside the blower fan of FIG. 4.

The impeller 108 is a turbofan that sucks the air from an upper portion thereof and blows out the air radially outward. Specifically, the impeller 108 includes a plurality of blades 108a, a side plate 108b having a ring shape, and a main plate 108c. As illustrated in FIG. 2, the impeller 108 is arranged so that a rotation axis thereof is directed to a height direction H (an up-and-down direction, or a vertical direction) of the unit. The impeller 108 is arranged so that the side plate 108b, the plurality of blades 108a, and the main plate 108c are provided in the stated order from the unit upper side.

Each of the plurality of blades 108a is formed so that not a radially inner portion but a radially outer portion thereof is positioned at the rear in a fan rotation direction RO. The plurality of blades 108a extend in the height direction between the side plate 108b and the main plate 108c.

The side plate 108b is positioned on an upstream side of the plurality of blades 108a, that is, on a fan air inlet 107a side in the impeller 108. The side plate 108b has a ring shape having an opening formed in a center thereof in plan view, and functions as a wall through which the air is sucked and guided. On the other hand, the main plate 108c is positioned on a fan air outlet 107b side in the impeller 108, and is connected to and astride lower ends of the plurality of blades 108a. A rotation shaft 109a of the motor 109 for rotationally driving the impeller 108 is fixed to the main plate 108c.

An outer diameter ϕDs of the side plate 108b of the impeller 108 is larger than an outer diameter ϕDm of the main plate 108c of the impeller 108. Further, regarding an outer diameter of each of the blades 108a, an outer diameter ϕDb1 on the side plate side in an extending direction of the rotation shaft 109a is larger than an outer diameter ϕDb2 on the main plate side.

The fan casing 110 includes a frame body 110a formed into a substantially rectangular parallelepiped shape, a bell-mouth 112 mounted to the frame body 110a, and four side wall surfaces 110b. The bell-mouth 112 is mounted to an upper portion of the frame body 110a, and has the fan air inlet 107a formed therein so as to be communicated to an impeller air inlet 108d. The four side wall surfaces 110b are removably mounted to corresponding side portions of the frame body 110a, respectively.

With this, it can be considered that an upper surface of the fan casing 110 having a substantially rectangular parallelepiped shape is formed by the bell-mouth 112, and that four side surfaces of the fan casing 110 are formed by the four side wall surfaces 110b. A further radially outer side of an impeller air outlet 108e of the impeller 108 is covered by side surfaces of the fan casing 110, and the side surfaces of the fan casing 110 can be opened and closed through mounting and dismounting of the side wall surfaces 110b.

Further, an opening is formed in a region corresponding to a bottom surface of the fan casing 110, which also serves as a surface opposed to the bell-mouth 112. The opening functions as the fan air outlet 107b. As illustrated in FIG. 2, the fan air outlet 107b is formed so as to be communicated to the unit air outlet 102. That is, the fan casing 110 has the fan air inlet 107a formed in an upper surface thereof, and has the fan air outlet 107b formed in a lower surface thereof.

Note that, the motor support 111 is positioned on the fan air outlet 107b side of the main plate 108c of the impeller.

In the air conditioning apparatus configured as described above, when the impeller 108 is rotationally driven by the motor 109 about a rotation center O, the air in the room 117 is sucked into the air conditioning apparatus through the unit air inlet 101. The air, from which dust is removed by the air cleaning filter 103, is cooled and dehumidified by the heat exchanger 104, guided to the bell-mouth 112 serving as the fan air inlet 107a of the blower fan 107, and sucked toward the impeller 108 from above. As illustrated in FIG. 7, the sucked air is subjected to actions of the plurality of blades 108a, and thus is blown out from sides of the impeller 108, that is, from the impeller air outlet 108e. In addition, the sucked air is deflected downward by the side wall surfaces 110b of the fan casing 110. That is, the air sucked toward the impeller 108 is once blown out toward the sides different from the fan air outlet 107b, and is deflected to the fan air outlet 107b under the actions of the side wall surfaces 110b of the fan casing 110. Then, the sucked air flows through the unit air outlet 102 into the underfloor space 119.

According to the air conditioning apparatus of the first embodiment configured as described above, the following excellence can be obtained. First, in the air conditioning apparatus according to the first embodiment, the air sucked toward the impeller is once blown out toward the sides different from the fan air outlet, and is deflected to the fan air outlet under the actions of the side wall surfaces of the fan casing, to thereby be sent from the unit air outlet. Accordingly, as compared to a case where the air is directly blown out from the impeller toward the unit air outlet, velocity of the air flowing out from the unit air outlet is satisfactorily reduced in the first embodiment. Accordingly, velocity of the air flowing into the underfloor space is low, and hence the air is prevented from colliding with a bottom surface of the underfloor space while keeping a high-velocity flow. Thus, airflow resistance can be reduced, and particularly in a property that does not allow a long distance to the bottom surface of the underfloor space and has a small-height underfloor space, an effect of reducing airflow resistance can be significantly obtained, which is effective. Accordingly, finally, power consumption of the motor can be reduced, and energy saving can be achieved. Further, the blown-out air flows at low velocity, and hence it is possible to reduce a problem in that the blown-out air stirs up dust underneath the floor. That is, it is possible to obtain an energy-saving, silent, and high-quality air conditioning apparatus.

In addition, according to the first embodiment, in a mode in which each of the blower fans is arranged below the heat exchanger, the fan air inlet is formed in the upper surface of the fan casing. Accordingly, unlike a case where the fan air inlet is formed in a side surface of the fan casing, it is possible to prevent local concentration of the air flow. Therefore, when the air is sucked from the heat exchanger arranged above the fan air inlet, wind velocity is equalized over the fan air inlet, and is not increased locally. Accordingly, reduction in noise level can be achieved.

Further, the outer diameter ϕDs of the side plate of the impeller is larger than the outer diameter ϕDm of the main plate of the impeller. Thus, when the airflow from the impeller air outlet is deflected by the side wall surfaces of the fan casing, an airflow path is enlarged on the main plate side of the impeller, and hence the airflow is easily deflected. With this, airflow resistance can be further reduced, and power consumption of the motor can be further reduced.

Further, the outer diameter ϕDb1 of each of the blades on the side plate side is larger than the outer diameter ϕDb2 of each of the blades on the main plate side, and hence an air blowing amount in a side-plate-side region of each blade can be increased as compared to an air blowing amount in a main-plate-side region of each blade. Thus, the airflow is easily deflected toward the fan air outlet. As a result, it is possible to reduce power consumption of the motor, and it is possible to reduce noise caused when the airflow collides with wall surfaces when deflected. That is, also with this, it is possible to obtain an air conditioning apparatus capable of saving energy and reducing noise level.

Further, the plurality of blower fans are provided, and hence the air can be sucked in a large range. Even when the heat exchanger has an elongate body, a wind velocity distribution in the heat exchanger can be equalized. Accordingly, the heat exchanger can be employed effectively, and it is not necessary to increase an air blowing amount uselessly. Also with this, power consumption of the motor can be reduced, and reduction in noise level can be achieved.

Further, the plurality of blower fans are arranged with an interval in the widthwise direction, and hence it is possible to prevent the adjacent fans from scrambling for the airflow toward the fan air inlets. With this, airflow resistance can be reduced, and the airflow can be sucked into the heat exchanger in a large range. Also with this, reduction in power consumption of the motor and reduction in noise level can be achieved.

In a case where the plurality of blower fans are controlled so as to have mutually different numbers of revolutions of the fans, it is possible to suppress beat noise between adjacent fans caused in a case where the fans are controlled so as to have the same number of revolutions (for example, in a case where the plurality blower fans are driven by one motor), and hence audibility can be enhanced. Further, in a case where an installation position is set to a corner section of a room so that an air outlet space for one of the blower fans is narrow and an air outlet space for another one of the blower fans is wide, when the fans are controlled so as to have the same number of revolutions, there is a fear in that airflow resistance of one of the blower fans becomes extremely high, to thereby cause increase in power consumption of the motor. However, the fans are controlled so as to have mutually different numbers of revolutions of the fans, and thus airflow resistance can be adjusted. Further, power consumption of the motor can be reduced.

The fan casing includes the frame body and at least one side wall surface removably mounted to the frame body, and hence a side surface of the fan casing can be opened and closed. Accordingly, there is an advantage in that replacement work is easily performed even if the impeller or the motor is broken or damaged. Further, strength can be ensured owing to the frame body, and hence the fan casing does not need to be thick entirely. Thus, weight and an amount of a material can be reduced. In addition, a material for a part of wall surfaces forming the fan casing can be changed or varied from a material for the frame body and the other wall surfaces. For example, when a reinforced transparent resin is employed as a material for a part of wall surfaces, an operation state of the fan can be easily checked only through removal of a side plate of the main body, and hence a construction property and a maintenance property can be enhanced.

Further, the motor support is positioned closer to the side on which the fan air outlet is formed than the main plate of the impeller. That is, this leads to separation of the motor support from the fan air inlet, and thus it is possible to obtain a mode in which the air passes around the motor support at a stage where the wind velocity is reduced in a route of the airflow from the fan air inlet to the fan air outlet. Also with this, reduction in airflow resistance and suppression of degradation of noise level can be achieved. Further, the airflow toward the fan air outlet can be deflected by the motor support toward the fan air outlet. That is, the motor support can exert a function of supporting the motor, and a function as an air guiding plate.

Further, side surfaces of the fan casing include at least one flat surface. As an example of the fan casing, in the first embodiment, the fan casing exhibits a rectangular shape in plan view. Regarding this, for example, in a case where the fan casing has a cylindrical shape and a side wall surface of the fan casing exhibits a circular shape in plan view, the airflow circles, and hence the airflow is not smoothly deflected toward the fan air outlet by the side wall surface of the fan casing. As a result, there is a fear in that an air blowing amount is reduced, and thus power consumption of the motor may be deteriorated. On the other hand, in the first embodiment, as described above, the fan casing exhibits a rectangular shape in plan view, and hence four surfaces and four corners are secured on the side surfaces of the fan casing. The airflow blown out from the impeller air outlet is prevented from circling, and is effectively and reliably deflected toward the fan air outlet by large flat surfaces serving as the side wall surfaces. Accordingly, also with this, it is possible to obtain an effect of reducing power consumption of the motor.

Further, the heat exchanger has a V-shape, that is, has a shape including at least one bent portion. Thus, an area of the heat exchanger can be enlarged, and heat transferring performance is enhanced. Accordingly, even in a case of the same air blowing amount, a heat exchange amount can be increased. Therefore, in a case of the same heat exchange amount, an air blowing amount can be further reduced, and power consumption of the motor can be reduced.

### Second Embodiment

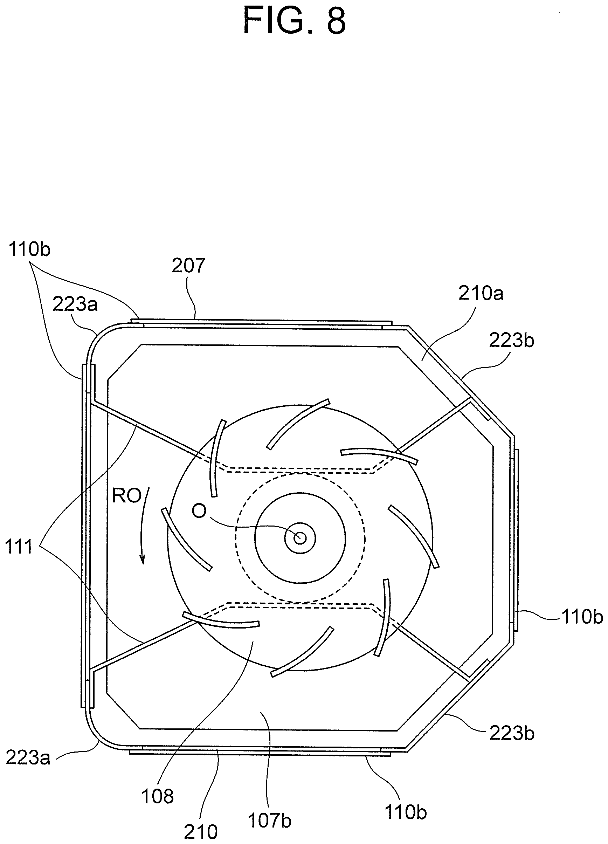

Next, an air conditioning apparatus according to a second embodiment of the present invention is described. FIG. 8 is a view illustrating the second embodiment and corresponding to FIG. 5. Note that, the second embodiment has the same configuration as that of the above-mentioned first embodiment except for components to be described below.

A fan casing 210 of a blower fan 207 according to the second embodiment includes a pair of rounded portions 223a and a pair of chamfered portions 233b at portions thereof corresponding to corners of a rectangular shape with reference to the rectangular shape of the fan casing 110 in plan view.

Also in the second embodiment, the same advantage as that of the first embodiment can be obtained. Further, also in the second embodiment, the side surfaces of the fan casing include at least one flat surface, and hence similarly to the first embodiment, the airflow blown out from the impeller air outlet is prevented from circling, and is effectively and reliably deflected toward the fan air outlet by large flat surfaces serving as side wall surf aces . In addition, in the second embodiment, at least one chamfered portion is formed at a portion of the fan casing corresponding to a corner of a rectangular shape with reference to the rectangular shape of the fan casing 110 in plan view. Accordingly, piping and wiring can be provided in a space formed outside the chamfered portion of the fan casing, and upsizing of a dimension of the unit can be suppressed. That is, it is possible to obtain an air conditioning apparatus that is easily downsized while realizing reduction in power consumption of the motor along with reduction in airflow resistance.

### Third Embodiment

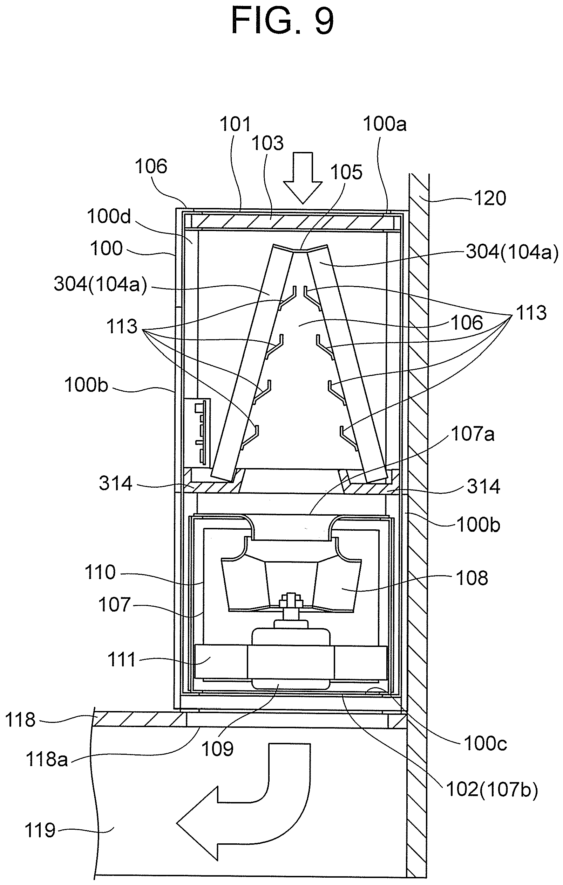

Next, an air conditioning apparatus according to a third embodiment of the present invention is described. FIG. 9 is a view illustrating the third embodiment and corresponding to FIG. 2. Note that, the third embodiment has the same configuration as that of the above-mentioned first or second embodiment except for components to be described below. As an example, FIG. 9 illustrates a case where the third embodiment is implemented in combination with the above-mentioned first embodiment.

In the third embodiment, a heat exchanger 304 includes the two heat exchanger forming sections 104a arranged in an inverted V-shape. Below a lower end of each of the heat exchanger forming sections 104a, a drain pan 314 is provided.

Also in the third embodiment, the same advantage as that of the corresponding first or second embodiment can be obtained. In addition, in the third embodiment, the heat exchanger has an inverted V-shape, and hence it is possible to realize such a layout that the fan air inlet is arranged in a space on a side of an interval between the heat exchanger forming sections. The drain pan is not positioned near the fan air inlet nor directly above the fan air inlet, with the result that reduction in airflow resistance and suppression of a drift are accelerated. Also with this, reduction in power consumption of the motor and reduction in noise level can be achieved.

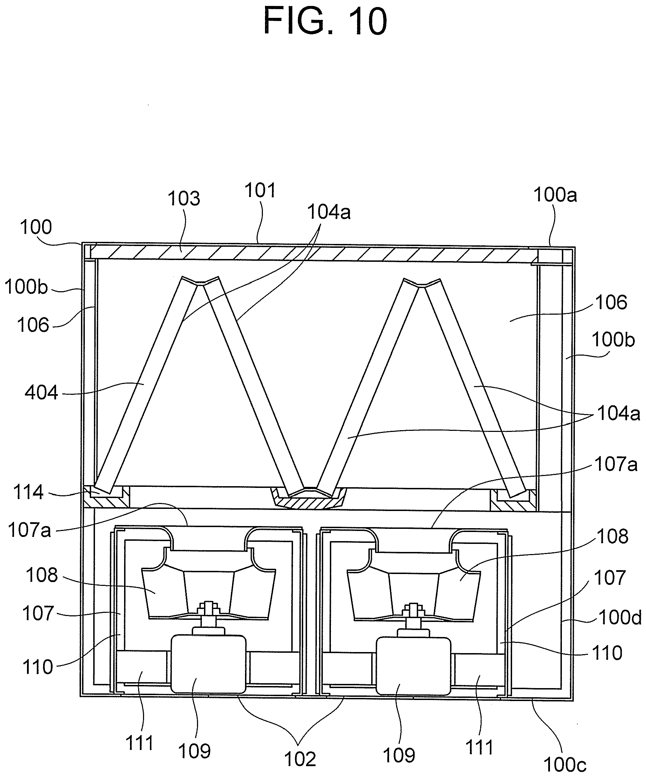

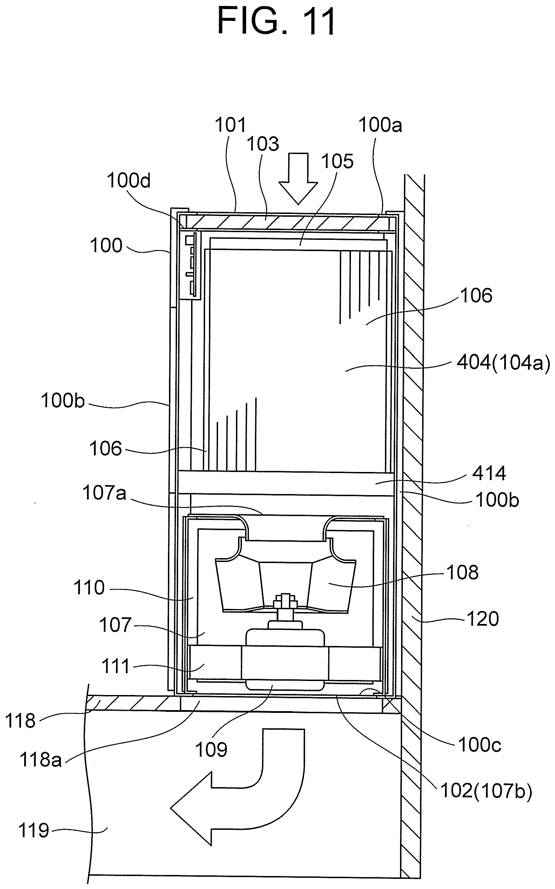

Further, the above-mentioned feature of the third embodiment is not limited to forming the heat exchanger into an inverted V-shape. FIG. 10 is a view illustrating a modified example of the third embodiment and corresponding to FIG. 3, and FIG. 11 is a view illustrating the modified example of the third embodiment and corresponding to FIG. 2.

As the third embodiment, a heat exchanger 404 includes four heat exchanger forming sections 104a arranged in an M-shape. Below a lower end of each of the heat exchanger forming sections 104a, a drain pan 414 is provided. Note that, the above-mentioned M-shape is viewed from a lateral side orthogonal to such an aligning direction of the blower fans that the plurality of blower fans appear to overlap each other.

Also in this modified example, similarly to a case where the heat exchanger having an inverted V-shape illustrated in FIG. 9 is provided, the drain pan is not positioned near the fan air inlet nor directly above the fan air inlet, and thus reduction in airflow resistance and suppression of the drift can be achieved.

Although the details of the present invention are specifically described above with reference to the preferred embodiments, it is apparent that persons skilled in the art may adopt various modifications based on the basic technical concepts and teachings of the present invention. For example, a single blower fan may be used.

### Reference Signs List

100 unit main body, 104, 304, 404 heat exchanger, 104a heat exchanger forming section, 107, 207 blower fan, 107a fan air inlet, 107b fan air outlet, 108 impeller, 108a blade, 108b side plate, 108c main plate, 108d impeller air inlet, 108e impeller air outlet, 109 motor, 110, 210 fan casing, 110a, 210a frame body, 110b side wall surface, 111 motor support.

## Claims

1. An air conditioning apparatus, comprising:
a unit main body (100);
a heat exchanger (104, 204, 304, 404); and
at least one blower fan (107, 207),
wherein the heat exchanger (104, 204, 304, 404) is arranged on an upstream side of the blower fan (107, 207),
wherein the blower fan (107, 207) comprises an impeller (108), a motor (109), and a fan casing (110, 210),
wherein the impeller (108) comprises a turbofan that sucks air from an upper portion thereof and blows out the air radially outward,
wherein a rotation axis of the impeller (108) is directed to a unit height direction,
wherein the fan casing (110, 210) has a fan air inlet (107a) formed in an upper surface thereof, and has a fan air outlet (107b) formed in a lower surface thereof, and
wherein an impeller air outlet (108e) of the impeller (108) is covered by side surfaces of the fan casing (110, 210),
wherein the impeller (108) comprises a plurality of blades (108a), a side plate (108b) having a ring shape, and a main plate (108c),
wherein the side plate (108b) is positioned on the fan air inlet side, and the main plate (108c) is positioned on the fan air outlet side, **characterized in that**
an outer diameter (ϕDs) of the side plate (108b) is larger than an outer diameter (ϕDm) of the main plate (108c),
wherein the side surfaces of the fan casing (110, 210) comprise at least one flat surface,
the fan casing (210) comprises at least one chamfered portion (223b), with reference to a rectangular shape of the fan casing in plane view, at a portion corresponding to a corner of the rectangular shape, and
a space penetrating in a vertical direction is formed on the outside of the chamfered portion (223b).

2. An air conditioning apparatus according to claim 1, wherein the blower fan (107, 207) is arranged below the heat exchanger (104, 204, 304, 404).

3. An air conditioning apparatus according to claim 1 or 2, wherein an outer diameter (ϕDb1) of each of the blades (108b) on the side plate side is larger than an outer diameter (ϕDb2) of each of the blades (108b) on the main plate side.

4. An air conditioning apparatus according to any one of claims 1 to 3, the air conditioning apparatus comprises a plurality of blower fans (107, 207).

5. An air conditioning apparatus according to claim 4, wherein the plurality of blower fans (107, 207) are arranged with an interval in a widthwise direction.

6. An air conditioning apparatus according to claim 4 or 5, wherein the plurality of blower fans (107, 207) are controlled so as to have mutually different numbers of revolutions of the fans.

7. An air conditioning apparatus according to any one of claims 1 to 6, wherein the fan casing (110, 210) comprises a frame body (110a, 210a), and at least one side wall surface (110b) removably mounted to the frame body (110a, 210a).

8. An air conditioning apparatus according to claim 1,
wherein the blower fan (107, 207) comprises a motor support (111), and
wherein the motor support (111) is positioned on the fan air outlet side of the main plate (108c) of the impeller (108).

9. An air conditioning apparatus according to any one of claims 1 to 8, wherein the heat exchanger (104, 204, 304, 404) has a shape comprising at least one bent portion.

10. An air conditioning apparatus according to any one of claims 1 to 9, wherein the heat exchanger (304, 404) has an inverted V-shape or an M-shape.

## Patentansprüche

1. Klimaanlage, umfassend:
einen Einheit-Hauptkörper (100);
einen Wärmetauscher (104, 204, 304, 404); und
zumindest einen Gebläselüfter (107, 207),
wobei der Wärmetauscher (104, 204, 304, 404) auf einer stromaufwärtigen Seite des Gebläselüfters (107, 207) angeordnet ist,
wobei der Gebläselüfter (107, 207) ein Flügelrad (108), einen Motor (109), und ein Lüftergehäuse (110, 210) umfasst,
wobei das Flügelrad (108) einen Turbolüfter umfasst, der Luft aus einem oberen Abschnitt davon ansaugt und die Luft radial nach außen bläst,
wobei eine Rotationsachse des Flügelrads (108) in eine Höhenrichtung der Einheit gerichtet ist,
wobei das Lüftergehäuse (110, 210) einen Lüfter-Lufteinlass (107a) aufweist, der in einer oberen Oberfläche desselben ausgebildet ist, und einen Lüfter-Luftauslass (107b) aufweist, der in einer unteren Oberfläche desselben ausgebildet ist, und
wobei ein Flügelrad-Luftauslass (108e) des Flügelrads (108) von Seitenoberflächen des Lüftergehäuses (110, 210) bedeckt ist,
wobei das Flügelrad (108) eine Vielzahl von Flügeln (108a), eine Seitenplatte (108b), die eine Ringform aufweist, und eine Hauptplatte (108c) umfasst,
wobei die Seitenplatte (108b) auf der Lüfter-Lufteinlassseite positioniert ist und die Hauptplatte (108c) auf der Lüfter-Luftauslassseite positioniert ist, **dadurch gekennzeichnet, dass**
ein Außendurchmesser ϕDs) der Seitenplatte (108b) größer ist als ein Außendurchmesser (ϕDm) der Hauptplatte (108c),
wobei die Seitenoberflächen des Lüftergehäuses (110, 210) zumindest eine flache Oberfläche umfassen,
das Lüftergehäuse (210) mit Bezug auf eine rechteckige Form des Lüftergehäuses in der Draufsicht an einem Abschnitt, der einer Ecke der rechteckigen Form entspricht, zumindest einen abgeschrägten Abschnitt (223b) umfasst, und
ein Raum, der in einer vertikalen Richtung vorsteht, an der Außenseite des abgeschrägten Abschnitts (223b) ausgebildet ist.

2. Klimaanlage nach Anspruch 1, wobei der Gebläselüfter (107, 207) unter dem Wärmetauscher (104, 204, 304, 404) angeordnet ist.

3. Klimaanlage nach Anspruch 1 oder 2, wobei ein Außendurchmesser (ϕDb1) von jedem der Flügel (108b) auf der Seitenplattenseite größer ist als der Außendurchmesser (ϕDb2) von jedem der Flügel (108b) auf der Hauptplattenseite.

4. Klimaanlage nach einem der Ansprüche 1 bis 3, wobei die Klimaanlage eine Vielzahl von Gebläselüftern (107, 207) umfasst.

5. Klimaanlage nach Anspruch 4, wobei die Vielzahl von Gebläselüftern (107, 207) mit einem Intervall in einer Breitenrichtung angeordnet sind.

6. Klimaanlage nach Anspruch 4 oder 5, wobei die Vielzahl von Gebläselüftern (107, 207) so gesteuert werden, dass sie gegenseitig unterschiedliche Drehzahlen der Lüfter aufweisen.

7. Klimaanlage nach einem der Ansprüche 1 bis 6, wobei das Lüftergehäuse (110, 210) einen Rahmenkörper (110a, 210a) und zumindest eine Seitenwandoberfläche (110b), die entfernbar am Rahmenkörper (110a, 210a) montiert ist, umfasst.

8. Klimaanlage nach Anspruch 1,
wobei der Gebläselüfter (107, 207) einen Motorträger (111) umfasst, und
wobei der Motorträger (111) auf der Lüfter-Luftauslassseite der Hauptplatte (108b) des Flügelrads (108) positioniert ist.

9. Klimaanlage nach einem der Ansprüche 1 bis 8, wobei der Wärmetauscher (104, 204, 304, 404) eine Form aufweist, die zumindest einen gebogenen Abschnitt umfasst.

10. Klimaanlage nach einem der Ansprüche 1 bis 9, wobei der Wärmetauscher (304, 404) eine umgekehrte V-Form oder eine M-Form aufweist.

## Revendications

1. Appareil de climatisation, comprenant :
un corps principal d'unité (100) ;
un échangeur de chaleur (104, 204, 304, 404) ; et
au moins un ventilateur de soufflante (107, 207),
dans lequel l'échangeur de chaleur (104, 204, 304, 404) est agencé sur un côté amont du ventilateur de soufflante (107, 207),
dans lequel le ventilateur de soufflante (107, 207) comprend une roue (108), un moteur (109) et un boîtier de ventilateur (110, 210),
dans lequel la roue (108) comprend un turboréacteur qui aspire l'air depuis une partie supérieure de celui-ci et expulse l'air radialement vers l'extérieur,
dans lequel un axe de rotation de la roue (108) est dirigé dans une direction de hauteur d'unité,
dans lequel le boîtier de ventilateur (110, 210) comporte une entrée d'air de ventilateur (107a) formée dans une surface supérieure de celui-ci, et comporte une sortie d'air de ventilateur (107b) formée dans une surface inférieure de celui-ci, et
dans lequel une sortie d'air de roue (108e) de la roue (108) est recouverte par les surfaces latérales du boîtier de ventilateur (110, 210),
dans lequel la roue (108) comprend une pluralité de pales (108a), une plaque latérale (108b) ayant une forme d'anneau, et une plaque principale (108c),
dans lequel la plaque latérale (108b) est positionnée sur le côté d'entrée d'air de ventilateur, et la plaque principale (108c) est positionnée sur le côté de sortie d'air de ventilateur, **caractérisé en ce que**
un diamètre externe ϕDs) de la plaque latérale (108b) est supérieur à un diamètre externe (ϕDm) de la plaque principale (108c),
dans lequel les surfaces du boîtier de ventilateur (110, 210) comprennent au moins une surface plate,
le boîtier de ventilateur (210) comprend au moins une partie chanfreinée (223b), en référence à une forme rectangulaire du boîtier de ventilateur en vue en plan, au niveau d'une partie correspondant à un coin de la forme rectangulaire, et
un espace pénétrant dans une direction verticale est formé sur l'extérieur de la partie chanfreinée (223b).

2. Appareil de climatisation selon la revendication 1, dans lequel le ventilateur de soufflante (107, 207) est agencé au-dessous de l'échangeur de chaleur (104, 204, 304, 404).

3. Appareil de climatisation selon la revendication 1 ou 2, dans lequel un diamètre externe (ϕDb1) de chacune des pales (108b) sur le côté de plaque latérale est supérieur à un diamètre externe (ϕDb2) de chacune des pales (108b) sur le côté de plaque principale.

4. Appareil de climatisation selon l'une quelconque des revendications 1 à 3, l'appareil de climatisation comprenant une pluralité de ventilateurs de soufflante (107, 207).

5. Appareil de climatisation selon la revendication 4, dans lequel la pluralité de ventilateurs de soufflante (107, 207) sont agencés avec un intervalle dans la direction de la largeur.

6. Appareil de climatisation selon la revendication 4 ou 5, dans lequel la pluralité de ventilateurs de soufflante (107, 207) sont commandés de façon à avoir des nombres de tours des ventilateurs mutuellement différents.

7. Appareil de climatisation selon l'une quelconque des revendications 1 à 6, dans lequel le boîtier de ventilateur (110, 210) comprend un corps de cadre (110a, 210a), et au moins une surface de paroi latérale (110b) montée de façon amovible sur le corps de cadre (110a, 210a).

8. Appareil de climatisation selon la revendication 1,
dans lequel le ventilateur de soufflante (107, 207) comprend un support de moteur (111), et
dans lequel le support de moteur (111) est positionné sur le côté de sortie d'air de ventilateur de la plaque principale (108c) de la roue (108).

9. Appareil de climatisation selon l'une quelconque des revendications 1 à 8, dans lequel l'échangeur de chaleur (104, 204, 304, 404) a une forme comprenant au moins une partie courbée.

10. Appareil de climatisation selon l'une quelconque des revendications 1 à 9, dans lequel l'échangeur de chaleur (304, 404) a une forme en V inversé ou une forme en M.
